# EUROPEAN PATENT APPLICATION

(11) **EP 1 191 723 A1**
(43) Date of publication of application: **27.03.2002**
(21) Application number: 99958189.5
(22) Date of filing: 19.11.1999
(51) Int. Cl.: H04H 9/00

(54) **RADIOPHONIC AUDIENCE CUSTOMIZING AND PICK-UP DEVICE**

(30) Priority: 20.11.1998 ES 9802942 U; 20.11.1998 ES 9901339 U; 20.11.1998 ES 9901340 U; 20.11.1998 ES 9901341 U
(71) Applicant: Global Standards, S.L., 28224 Madrid (ES)
(72) Inventor: MARCOS ALBA, Fernando, E-28224 Madrid (ES)
(86) International application number: ES9900372
(87) International publication number: WO0031907

(57) **Abstract**

The signal is picked-up by the antenna (1), amplified at (2), mixed at (4) with the signal generated in the local voltage-controlled oscillator (17), amplified at the intermediary frequency stage (5), supplied to the detector (6) and amplified at (7) to supply the loud-speakers (8). Only certain predetermined values can be introduced in the divider (13) of the PLL loop and, as a result the receiver can only be tuned to certain frequencies comprised in each band. Such device is appropriate to set up a communication channel defined between one or a plurality of radio broadcasting stations/channels, and is therefore capable of increasing and customizing the audience of such radio stations. Various alternatives are considered; analog or digital tuning; by direct set up of the frequency or by scanning and comparison; use of the RDS/RBDS systems; operation in frequency bands of analog radio broadcasting (modulation of amplitude and modulation of frequency) and of digital radio broadcasting (DAB Eureka-147/IBOC/IBAC).

## Description

Radiophonic audience loyalty-generating and pick-up device consisting in a radio receiver intended for reception into commercial broadcasting frequency bands that is pretuned to some predetermined frequencies. The aforesaid loyalty-generating and pick-up device by being located at a certain place, will be able to correctly receive broadcast programmes from those radio stations allocated to the above mentioned frequencies for that particular location and bound to the hearing of those programmes only.

### Technical Sector.-

This device consists of an specialized radio receiver. Therefore it falls into the area of telecommunication appliances.

### State of the art.-

Today's scene of mass media and broadcasting stations in particular in most of the countries in which these media are much developed is that of a strong competition to enlarge their respective audience. Competition in this sense is measured, in absolute terms, by the number of listeners whereas, in relative terms, it depends on the audience quota of listeners, audience share or simply "share", which provide us with the percentage of radio listeners who at a given span of time listen to a special radio station, compared to the total of listeners who are listening to any radio station during the same span of time (or a smaller group of listeners in the case of specialized channels). Broadcasters try to enlarge their audience share as much as they can, since their benefits from advertising spots strongly depend on the said quota. Likewise their social importance becomes more relevant. On the other hand, as listeners are free to tune whatever radio station they fancy to listen to, broadcasters are permanently interested to find out their listeners' likings to fit their programmes accordingly.

Thus, broadcasters spend large efforts to get a better knowledge of their respective audience so as to meet with their requirements as best as they can. Broadcasters are constantly trying to better their programming by offering new an original productions to their regular listeners, to the listeners of other radio stations as well as to casual radio listeners.

At present, the question of how to draw in more radio listeners and make them remain attached to a particular radio station is based on sociological issues and the solutions searched for to this problem lie on the same outlook.

A different approach based on technical issues is proposed to the problem of growing up and generate loyalty to a given radio-station.

It'll be interesting to analyse first how do broadcasting receivers work, so that the contrast with our invention will come out under a new light to clearly show the utility of it, when described further down.

Broadcasting receivers have a tuning button by which the reception frequency can be altered. This will allow the user: 1) to select just one of the various radio stations which broadcast on commercial bands. 2) to get a fine tuning, once the station has been selected.

Conventional receivers have a little wheel (or a cursor that moves straightforwardly) whose turning produces a change of value on the variable capacitors that are part of the tuning circuit, either because the motion directly brings about the change of the capacitance, or because its capacity is that of varicap diodes. If such is the case, movements will produce a change on the continuous control voltage which ultimately modifies the varicap capacitance. Whichever the way, the tuning of any radio station over the dial is the result of that change. In such cases, they usually build in auxiliary circuits for the visual aid of the tuning or some other indicator of the tuning level (for example, a needle that moves one side or the other to indicate at which point the best tuning is reached. It also tends to show the scale cero as soon as the dial slightly moves either to the left or to the right of the point at which the tuning is at its best. One or several photo-emitting diodes (LED) are also used to cover the same purpose. Sometimes it is a small lamp which gets brighter and brighter as the tuning gets better and better). This is meant to make fine adjustment easier. The previously described techniques are known as analogical tuning.

Sophisticated radio sets usually comprise additional circuits for easing the first function described (selection of a radio station/chain); for example, a PLL (Phase Locked Loop) based tuner can be built using a quartz oscillator and some programmable frequency dividers. Receivers based on PLL tuners use to comprise a kind of digital display to show the tuned frequency and a keyboard for changing the tuning frequency. Another technique that can be used is the so called DDS (Direct-Digital-Synthesis), which lead to a variable frequency high spectral purity wave by means of digital techniques and D/A (digital to analog) conversion. These type of circuits do not require fine tuning because they let the user to select the exact frequency required for tuning each station. Both examples fall into the digital tuning techniques (which should not be confused with digital radio broadcasting techniques).

During last years several novel broadcasting systems based on digital techniques have been developed, which are known as DAB (Digital-Audio-Broadcasting). European system known as Eureka-147 was adopted by the ETSI as an international standard during 1.995 and is considered the most advanced system proposed. According to these system, the radio signal that is going to be transmitted is firstly digitized, then compressed regarding the psychoacoustics characteristics of human hearing (using the so called MPEG or MUSICAM (Masking-Pattern-Adapted-Universal-Subband-Integrated-Codding-and-Multiplex-ing) technique. Before transmitting the signals an information multiplex is composed, using several signals each one corresponding to a single broadcast. The multiplex contains information that has been mixed in time and frequency domains by means of a technique called COFDM (Coded-Orthogonal-Frequency-Division-Multiplex). The information must be successively processed in order to optimize the energy that will be radiated by the station. Also, the information that is going to be transmitted is reinforced using redundancy techniques and subsequent error correction in the receiver. Information can be broadcasted from terrestrial stations (the so called T-DAB), by cable (C-DAB) or directly by satellite (S-DAB). From the user's point of view digital radio broadcasting means very high quality sound (equivalent to that of a Compact-Disc) and interference-free signal reception. Also, there is a possibility of sending data and low resolution video at a time. Additional information is sent for each program, the so called PAD ("Program-Associated-Data").

There are another systems. Among them should be distinguished that proposed by the American consortium WorldSpace, and the IBOC (In-Band-On-Channel) and IBAC (In-Band-Adjacent-Channel) systems. The first one is based on a very similar technology to that described for the Eureka-147 (relying upon intensive digital signal processing). The IBOC and IBAC systems work over the AM and FM bands, so that they can be adopted with the existing frequency allocation; digital radio broadcasting in the United States will follow this way. In these last systems, tuning can be performed as in conventional receivers. Then analog to digital conversion is performed, then digital signal processing, and last, digital to analog conversion and further amplification for driving the speakers.

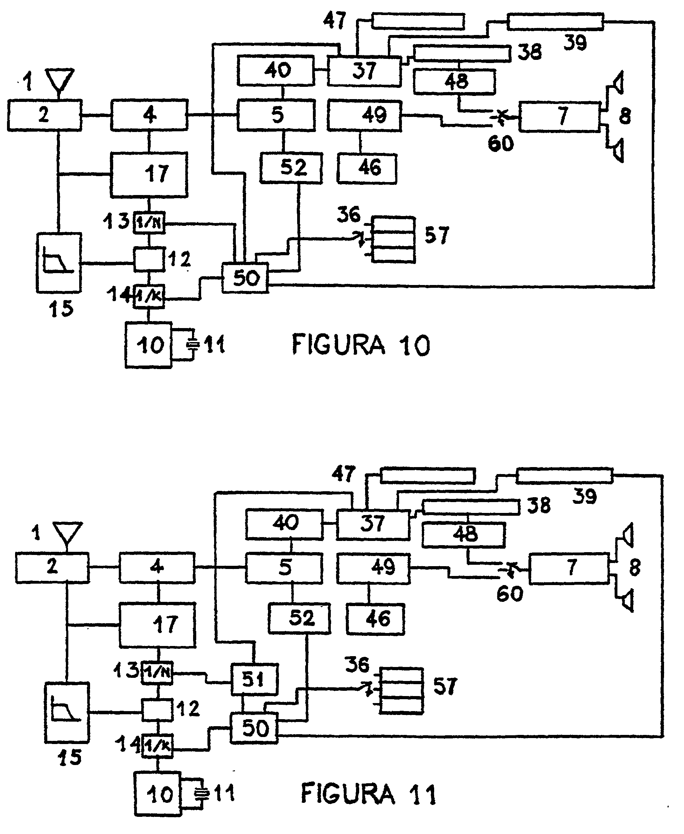

Figure 10 plots a block diagram of a receiver intended for digital radio broadcasting according to Eureka-147 standard. Provided the receiver may tune the so called S-DAB and the T-DAB (and that is the way adopted by the manufacturers of integrated circuits for digital receivers), two different antennae are needed, and also two different radiofrequency amplifiers, and a mixer for translating the satellite band over the terrestrial broadcasting band. The other circuits may be shared by both systems.

Should the device may also receive conventional analog broadcast, only the analog output stages can be shared by both systems: the audio amplifier and the speakers. A conventional radio receiver is required for receiving conventional analog broadcast.

Anyway, the existing radio receivers always come with a tuning control intended for choosing and changing among different radio stations/chains. They are universal receivers, and from the point of view of broadcasters they **lack selectivity**. Their **addressees** are the radio listeners, and their **function** is to let them tune any radio station/chain. The audience due to them is the natural audience of the radio station/chain, i.e., the audience derived from the listener's satisfaction due to the programs received. Existing radio receivers are unuseful for the objective of enlarging and make the radiophonic audience remain faithful to a given radio station/chain.

### Explanation of the invention:

Radio receivers intended for commercial broadcasting have been developed under a design philosophy in which the receiver can be tuned to any possible frequency (each frequency corresponding to the reception of a given radio station/chain). This is a deeply rooted philosophy in the radio design technique, so that radio designers haven't considered alternative scenario regarding this question.

This established scenario can be understood as a consequence of the user's interest in receiving the signals of different radio stations/chains with a single device.

But that scenario is not the unique one possible. A more general scenario can be considered where a receiver is conceived for satisfying the needs of third parties that may be other than the user of the receiver.

This generalization appears once a conception prejudice or model prejudice - implicitly assumed by commercial broadcasting radio receiver manufacturers and designers - is overcome.

In the established scenario, the receiver have been conceived for the satisfaction of the needs of the receiver's user. As there are a large variety in radio stations/chains, an indefinite communication channel arises between radio stations and users.

But another particular case can be considered inside the generalized scenario, that is dual for the established scenario. In this case the addressee of the device would be a broadcaster. Its needs are different from that of the radio listener, and could be focused in establishing a defined communication channel with the largest possible number of radio listeners.

The aforementioned concepts can be joined in the following table:

| | **Receiver designed for satisfaction the needs of:** | **Kind of needs** | **Kind of communication channel established between a given station and a user** |
|---|---|---|---|
| **Generalized scenario** | A given customer | Undetermined | Undetermined |
| **Established scenario** | Receiver's user | Information reception | Undefined |
| **Dual scenario (proposed invention)** | A given broadcaster | Enlarging its audience | Definite |

It is well known that a common source for inventions is the existence of unsatisfied needs: in the case considered, the interest in establishing a definite communication channel between radio stations and radio listeners. The proposed technical solution for this problem consists in a loyalty-generating and pick-up device based on a radio receiver in which the tuning frequency is fixed and correctly adjusted to a predetermined value. From the point of view of broadcasters, the **selectivity** of a pretuned loyalty-generating and pick-up device is complete, meaning that, in case the device is used, a unique signal can be obtained: that corresponding to the frequency to which it is pretuned to (so that the device can only receive a given radio station/chain in certain geographic area). In contrast with the universal receiver, the natural **addressee** for the device is a broadcaster, who should find the way for the device to reach the radio listeners. The **function** of the device is different to that of the universal receiver, because when used it will tune to a unique frequency. Thus, the device may be a very useful tool for enlarging and make the audience remain faithful to a given radio station/chain.

It is clear that, for this aforesaid need a receiver designed accordingly to the established scenario can be bettered. This is because the probability of a person x listening to a radio station α in a moment *t* can be expressed as:
*P*(*x*, α, *t*) = *P*₁(*x* wants to listen the radio at the instant t) · *P*₂ (a receiver is available for *x*) · *P*₃ (*x* choose α radio station) where as a first approach P₁can be supposed the same regardless the receiver were a conventional one or a device as this one proposed in the present invention. P₃ ≤ 1 for a conventional receiver, but P₃ = 1 for a device as proposed in the present invention; Late, the mere existence of these devices would give a raise to P₂.

As a variation, considering that a radio chain may own different frequencies depending on the region in which they operate, or even transmit on a band (for example AM) inside a region but on a different band (for example FM) for another region, it should be of interest that the loyalty-generating and pick-up device comprise a selector in order the user may choose the frequency and the band corresponding to the region in which he is, among a subset of frequencies of the band. Thus, the very same device could receive the signal of a given radio chain in different zones covered by that radio chain.

The possibility of choosing several frequencies among the whole frequencies comprised into the commercial bands makes sense a given loyalty-generating and pick-up device may receive the signal of two associated radio stations/chains or some radio stations/chains with complementary programs, that is, programs not competing for the same audience described in the introduction (for example, a radio station/chain specialized in news and another radio station/chain specialized in musical programs).

The existence of radio receivers comprising memories for storing programmable pretunes and pushbuttons for selecting in between should not be confused with the present invention, because such receivers simply offer a mean for easing the receiver tuning, but all these embodiments fall under the established scenario in which the receiver is oriented to the listener, arising an undefined communication channel.

Some FM radio stations/chains transmit additional data accompanying their regular programming according to RDS system in Europe or RBDS system in the United States. Both systems take advantage of an unused part of the spectrum assigned to each radio station and rely on a 57 kHz subcarrier. The additional data is intended for sending codes. These codes are useful for identifying each station, each program, the kind of program, etc., as much as for sending useful information regarding traffic, road accidents, weather, etc. This data can be recovered using specific decoders that are available even as integrated circuits.

RDS/RBDS systems allow switching between frequencies that are in use for the same programs, the so called alternative frequencies, or AF. Switching can be performed automatically, attending to the signal level of each alternative frequency detected by the receiver all the time. This property has been one of the most attractive figures offered by RDS/RBDS systems, and was specially developed for automotive receivers. Because of their movement, it may happen the program being listened gets a better signal on an alternative frequency allocated for the actual place. In general (also for non automotive applications) these systems allow tuning to the best possible signal owned by any alternative frequency assigned to a given radio chain.

Considering all the arguments exposed in the precedent section it is clear that, as a tool intended for broadcasters, the loyalty-generating and pick-up device offers a **completely new use** for commercial broadcasting receivers, thus opening a **new application field**.

### Description of figures.-

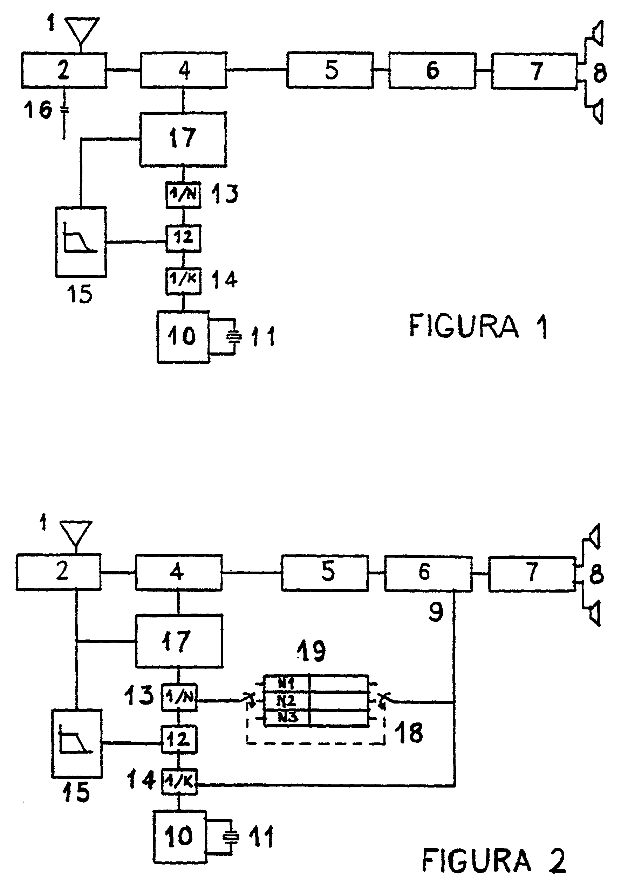

Figure 1 refers to a block diagram for a radiophonic audience loyalty-generating and pick-up device consisting in a radio receiver comprising a PLL frequency synthesizer pretuned to a single frequency.

Figure 2 refers to a block diagram for a radiophonic audience loyalty-generating and pick-up device consisting in a radio receiver comprising a PLL frequency synthesizer that can be tuned to some predetermined frequencies.

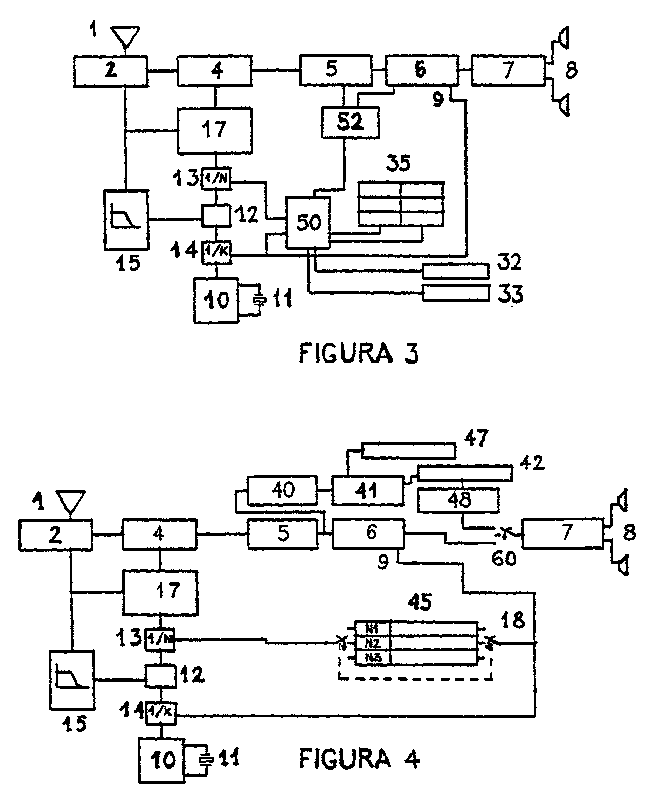

Figure 3 refers to a block diagram for a radiophonic audience loyalty-generating and pick-up device consisting in a radio receiver comprising a PLL frequency synthesizer that can be tuned to any frequencies but some included in a list of excluded frequencies.

Figure 4 refers to a block diagram for a radiophonic audience loyalty-generating and pick-up device consisting in a radio receiver comprising a PLL frequency synthesizer that can be tuned to some predetermined frequencies and comprising circuits for decoding digital radio broadcasted signals according to IBOC or IBAC systems.

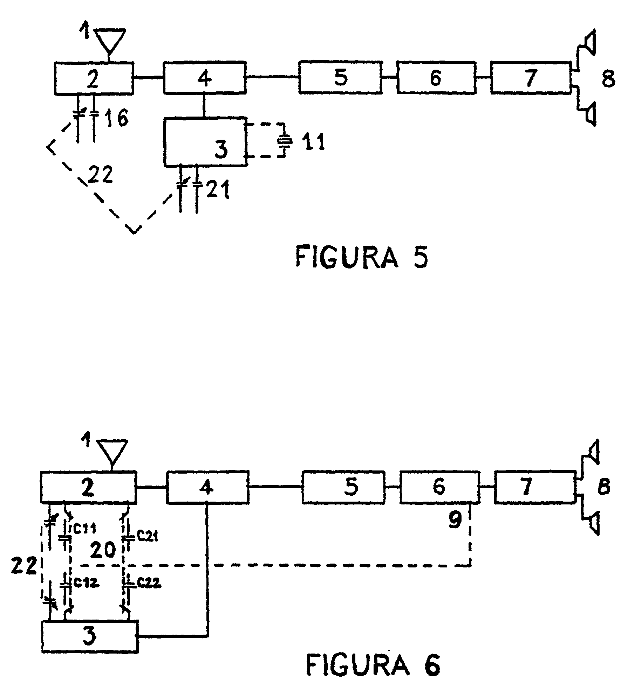

Figure 5 refers to a block diagram for a radiophonic audience loyalty-generating and pick-up device consisting in a radio receiver pretuned to a single frequency.

Figure 6 refers to a block diagram for a radiophonic audience loyalty-generating and pick-up device consisting in a radio receiver that can be tuned to some predetermined frequencies comprised into one or more bands intended for commercial radio broadcasting.

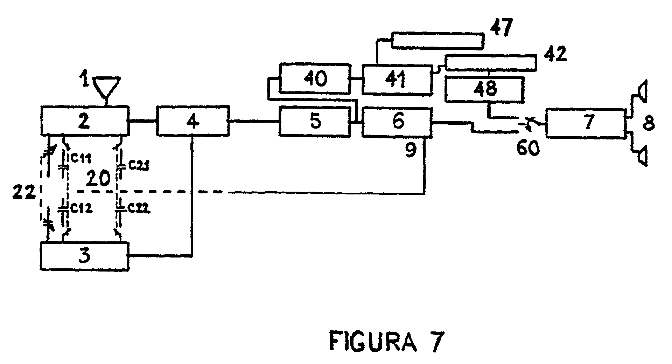

Figure 7 refers to a block diagram for a radiophonic audience loyalty-generating and pick-up device consisting in a radio receiver that can be tuned to some predetermined frequencies comprised into one or more bands intended for commercial radio broadcasting. The said device includes circuits for decoding digital radio broadcasted signals according to IBOC/IBAC systems.

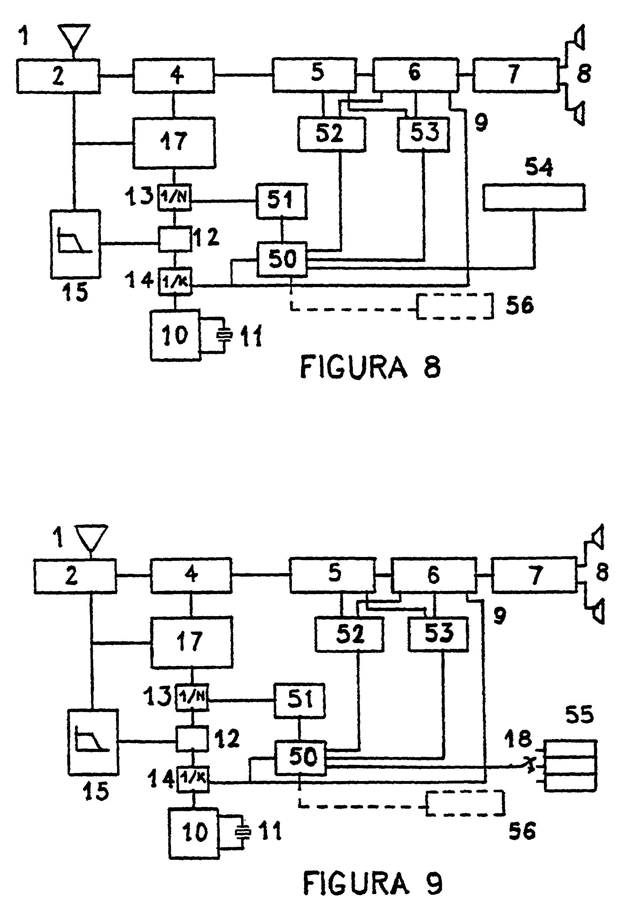

Figure 8 refers to a block diagram for a radiophonic audience loyalty-generating and pick-up device consisting in a radio receiver comprising a PLL frequency synthesizer and a decoder circuit for RDS/RBDS systems, which behaves as if it were pretuned to a single radio chain, due to some information that is stored and to an arrangement for sweeping through dial.

Figure 9 refers to a block diagram for a radiophonic audience loyalty-generating and pick-up device consisting in a radio receiver comprising a PLL frequency synthesizer and a decoder circuit for RDS/RBDS systems, which behaves as if it were pretuned to a radio chain chosen among some predetermined radio chains, due to some information that is stored and to an arrangement for sweeping through dial

Figure 10 refers to a block diagram for a radiophonic audience loyalty-generating and pick-up device consisting in a digital radio broadcasting receiver that might receive analog radio broadcasted signals. The said device behaves in the digital band as a radiophonic audience loyalty-generating and pick-up device pretuned to some frequencies and programs.

Figure 11 refers to a block diagram for a radiophonic audience loyalty-generating and pick-up device consisting in a digital radio broadcasting receiver that might receive analog radio broadcasted signals. The said device comprises a sweep generator and decoders for the program associated data (PAD) and it behaves in the digital band as a radiophonic audience loyalty-generating and pick-up device pretuned to some frequencies and programs.

### Marking list for figures.-

1. Receiving antenna (one or more, depending upon the receiver is to be tuned to frequencies belonging to bands that may require different antennae).
2. Radiofrequency amplifier (one or more, depending upon the receiver is to be tuned to frequencies belonging to bands that may require different radiofrequency amplifiers).
3. Local oscillator.
4. Mixer.
5. Intermediate frequency stage or stages (I.F.).
6. Detector circuit (or circuits).
7. Audio amplifier.
8. Speaker or speakers.
9. Switching for detector circuits (in order to activate the detector circuit corresponding to the band comprising the frequency to be tuned).
10. PLL main oscillator.
11. Crystal device for the oscillator.
12. Phase detector for the PLL loop.
13. Frequency divider for the PLL loop (programmable or programmed, depending upon the case).
14. Frequency divider for prescaling (or predivider) for the PLL loop (programmable or programmed, depending upon the case).
15. Low-pass filter for the PLL loop.
16. Capacitor determining the radiofrequency amplifier bandpass.
17. Voltage controlled oscillator (VCO).
18. Predetermined frequency selecting device.
19. Paired registers for storing: the values of the programmable frequency dividers corresponding to each predetermined frequency and the band comprising such frequencies.
20. Band segment selecting device.
21. Capacitor for determining the local oscillator frequency.
22. Capacitor tandem for fine tuning.
32. Tuning controls.
33. Frequency band selecting device.
35. Register matrix comprising the excluded frequency list.
36. Selecting device for choosing predetermined digital broadcasting radio stations/chains.
37. Digital signal processor for decoding information according to the Eureka-147 standard.
38. Audio decoder according to the Eureka-147 standard.
39. Additional information decoder for recovering the Program Associated Data (PAD) that is broadcasted with the main signals.
40. Analog to digital converter.
41. Digital signal processor for information decoding according to IBOC or IBAC systems.
42. Audio decoder according to IBOC or IBAC systems.
45. Paired registers for storing: the values of the programmable frequency dividers corresponding to each predetermined frequency and the band comprising such frequencies.
46. Tuning controls for analog radio broadcasting bands.
47. Device for displaying video information.
48. Digital to analog converter.
49. Analog radio receiver.
50. Tuning controller.
51. Sweep generator for tuning frequency.
52. Valid station detector.
53. RDS or RBDS systems decoder.
54. Register for storing the RDS or RBDS code corresponding to the predetermined station/chain.
55. Registers for storing the RDS or RBDS codes corresponding to the predetermined stations/chains.
56. Tuning control for AM.
57. Registers for storing the codes corresponding to predetermined digital radio broadcasting stations/chains.
60. Switching between audio signal coming from the analog receiver and that another one coming from the digital receiver.

### Embodiment of the invention:

First of all, it should be noted that, as a consequence of the technical development and the subsequent national and international regulation changes, the commercial radio broadcasting experienced a development on different frequency bands. Likewise, and due to the same reasons, different modulation techniques (as the amplitude modulation and the frequency modulation), different coding techniques (analog and digital) and different coding formats for digital techniques have been used. The digital techniques allow the embodiment of algorithms for data compression and even consider the psychoacoustics characteristics of the human hearing for a more effective use of the frequency spectrum. It is the case of the MUSICAM standard. All of it is related to sound broadcasting, as it is intended to communicate a sound by means of herzian waves. Continuous technological improvements have evolved bringing new ways for transforming the sound before transmitting it, despite all the transformations should be reversed after the reception of the waves, always looking for practical advantages as better sound quality, less radiated energy for the same coverage, or slighter influence from interferences and atmospheric conditions. This statement applies to all the aforementioned systems, even those for digital radio broadcasting. The latter, more flexible, can be used even for low resolution video transmission and text. For this reason, regardless of the system considered, there are always common elements like the antenna for picking up the radiofrequency signals (although its specifications and physical appearance may be varied), or the audio amplifier at the output which raises the power level of the retrieved signal for driving the speakers. Besides, there are other elements and specific circuits depending on the frequency band, the modulation technique, the coding technique, the format adopted, and so on. Nevertheless, these elements play corresponding roles when retrieving the information from the broadcasted radio signal. Unlike other technical fields where technical improvements give rise to new products quickly and definitely replacing the previous ones, in the world of radio broadcasting the different technologies coexist nowadays due to acquired rights of broadcasters and users, and due to the shortage of the radioelectric spectrum. The inventive concept proposed **is independent of the frequency band, the modulation technique, the coding technique and the format adopted**. These subjects belong to the state of the art, and as the vocation of the device is to be in service of radio broadcasters, it should be adapted to the required technique and operational band in which the later operate, what, combined with the different receiver technologies in use give raise to a wide range of possible embodiments to be taken into consideration. Their description will be done starting from the superheterodyne receiver block diagram, provided it is the reference scheme for sound radio broadcasting. It should not be considered as a limitation, as it is well known that there are equivalent schemes on the state of the art from the point of view of the signal extraction, i.e., those based on direct conversion (so called because the transmission band is directly moved to the audio band, without intermediate frequency stages).

The radiophonic audience loyalty-generating and pick-up device can be built starting from a radio receiver intended for reception into commercial broadcasting frequency bands (figure 2) comprising a PLL (Phase Locked Loop) frequency synthesizer for the local oscillator, fitted with a selecting device (18) controlled by the radio listener and with several pairs of permanent registers (19) for storing the value of the frequency divider of the PLL loop and that of the prescaler and the frequency band to which each predetermined frequency belongs to. The selecting device sets the count value for the programmable frequency dividers (13) and (14) of the PLL loop, thus determining the local oscillator frequency and the bandpass for the radio frequency amplifier, and at the same time switches at (9) the detector circuit (6) according to the band comprising each predetermined frequency (if not all the predetermined frequencies belong to the same band), as well as those other elements that require it (the antenna, the radio frequency amplifier, etc.).

The device's property of being pretuned to one or several predetermined frequencies allows for a lot of variations when considering the use of receivers intended for commercial broadcasting frequency bands comprising a PLL (Phase Locked Loop) frequency synthesizer for the local oscillator. Inside each band, these receivers (figure 3) are tuned while pressing two pushbuttons (32): one of them for sweeping up through dial, and the other one for sweeping down through dial. The pushbuttons requests are applied to the tuning controller (50) which commands the values for the frequency dividers (13) and (14) of the PLL loop, in order to scan the whole dial. A radiophonic audience loyalty-generating and pick-up device can be built where some of the counting values that should be put into the programmable divider (13) of the PLL loop for a band being completely scanned are not allowed: there are some excluded values comprised in a table of excluded frequencies to which the loyalty-generating and pick-up device cannot be tuned to, for each frequency band. There are many ways for implementing this excluded frequencies table: it can be done using a matrix of registers (35) containing the counting values not allowed for the programmable divider (along with paired registers referring to the band involved, if it is required). In this case the tuning controller (50) shall compare each counting value requested from the tuning controls with the values stored in the matrix of registers before introducing them into the programmable divider, rejecting those included in the matrix of registers.

The excluded frequency table can be implemented also in the programmable divider itself. These programmable dividers are formed by flip-flops and a decoder. A wave is applied to its input which pulses are counted in a binary code by the flip-flops. When the circuit has counted as many pulses as determined by the decoder (this is the actual counting modulus of the divider), a pulse is generated at the output of the divider. The input to the decoder circuit determines the counting modulus of the divider. Of course the frequency of the wave outcoming the divider is lower or equal than that incoming to the divider. The relationship between the signals commanding the decoder and the counting modulus is known as the truth table of the programmable divider. It can be used a programmable divider with a decoder specifically designed in order its truth table avoids a set of counting values for each band, corresponding to excluded frequencies to which the receiver cannot tune to. The action over the main tuning control will produce the dial to be scanned jumping between predetermined frequencies to which the loyalty-generating and pick-up device is allowed to be tuned to.

In order to build a loyalty-generating and pick-up device allowed to receive just one frequency (figure 1), the fixed ratio dividers (13) and (14) of the PLL loop are used (or programmable dividers with counting modulus fixed to the required value). For this case, the radio frequency amplifier may be tuned by a fixed value component, as a capacitor (16), or by other kind of components (inductances, ceramic filters, SAW filters, etc.) or by a varactor biased from the output of the low pass filter (15) comprised in the PLL loop.

Figure 4 plots a block diagram for a radio receiver intended for the reception of conventional analog radio and also for the reception of digital radio according to American systems IBOC or IBAC. Digital radio broadcasting according to these last systems takes place in the very same frequency bands used for conventional analog radio broadcasting. Consequently, the antenna (1), the radiofrequency amplifier (2), the local oscillator (17), the mixer (4), the intermediate frequency stage (or stages) (5) may be shared by digital and analog receivers. An analog to digital converter (40) is connected to the output of the last intermediate frequency stage (5). Its output is then connected to a digital signal processor (41) and to a decoder (42) for extracting the high quality audio signal and other information sent together with the audio signal, intended for being shown on a display (47). Last, the audio signal is converted from digital to analog (48) and carried to an audio amplifier (7) for driving the speakers (8). The radio listener may choose among digital channel or analog channel using the switch (60). Both channels may be coincident or not, for the whole or just during some intervals, depending upon each station/chain criteria. The selecting device (18) controlled by the radio listener is intended for choosing one among several predetermined frequencies to which the loyalty-generating and pick-up device can be tuned. Each predetermined frequency owns a couple of registers in the matrix (45) of permanent registers in which is stored the counting value for the programmable divider of the PLL loop and the information about the frequency band in which the predetermined frequency is comprised. The selecting device must change not only the local oscillator frequency and the radio frequency amplifier bandpass but all the required circuits involved: antenna, intermediate frequency stages, detector circuits, etc.

Anyway, the predetermined frequencies to which the device can be tuned to are just a part of the whole set of frequencies allocated for commercial broadcasting by public authorities (i.e. it is impossible for the radio listener of the radiophonic audience loyalty-generating and pick-up device to tune the whole set of allocated frequencies in at least one band at which the receiver operates).

If the loyalty-generating and pick-up device is intended for tuning just one frequency, the selector device (18) is obviously superfluous.

The following embodiments are considered for making a loyalty-generating and pick-up device based on the conventional variable capacitor technology used for making commercial broadcasting radio receivers. In order the device should remain tuned to a predetermined frequency the tandem of capacitors used for tuning - which are used for changing the bandpass of the radio frequency amplifier and the local oscillator frequency - must be adjusted in the manufacturing process to fixed values proper for the reception of the said frequency. As these components suffer from thermal and aging drifts, there should be a fine tuning circuit for counteracting them. The capacitor tandem may be substituted (figure 5) by a fix capacitor for setting the radio frequency amplifier bandpass (16), a fix capacitor for setting the local oscillator frequency (21) and a capacitor tandem for fine tuning (22). The same result can be obtained with a local oscillator based in a quartz crystal (11) manufactured for oscillating at the fixed frequency required by the local oscillator in order the receiver to tune that predetermined frequency, which is a much more stable solution that doesn't need a fine tuning circuit. It is also possible to manufacture radio receivers with different components than capacitors for tuning; from varactors, to inductances (deeply used for automotive radios), even ceramic filters, SAW filters, or even integrating the distributed parasitic impedances due to connections (parasitic capacitances or parasitic inductances) as it is common practice for high frequency circuits. So, it is also possible to manufacture pretuned receivers with the aforementioned components, adjusting the required tuning frequency during the manufacturing process and leaving a fine tuning circuit, if necessary.

A possible embodiment for a loyalty-generating and pick-up device able for tuning some predetermined frequencies comprised into commercial broadcasting bands (figure 6) is a radio receiver further comprising a selecting device (20) for changing the required controls in order to let the receiver get tuned to each of the predetermined frequencies: the antenna (1), if required, the radio frequency amplifier bandpass (2), other tuneable amplifiers bandpass (if there are any), the local oscillator frequency (3), the proper detector circuit (6) corresponding to the band comprising each predetermined frequency (the switching for the detector circuits (6) intended for Amplitude Modulation (AM), Frequency Modulation (FM), etc., is marked (9)). In order to change the radio frequency amplifier bandpass and for setting the local oscillator frequency, the selecting device gives a jump change in the value of the tuning tandem capacitor, or, as plotted in figure 6, the selecting device changes among several sets of capacitors; for example: in order the predetermined frequency n° 1 to be tuned, capacitor C11 (for the radio frequency amplifier) and capacitor C12 (for the local oscillator) should be in use, in order the predetermined frequency n° 2 to be tuned, capacitor C21 (for the radio frequency amplifier) and capacitor C22 (for the local oscillator) should be in use, etc. (always referred to an embodiment based in capacitors). A fine tuning circuit and a control key (22) may be required for components drift compensation. If the control range of the fine tuning circuit is enlarged, the loyalty-generating and pick-up device may tune several clusters of adjacent predetermined frequencies.

Figure 7 is a plot of a block diagram for a radio receiver intended for the reception of conventional analog radio and also for the reception of digital radio according to American systems IBOC or IBAC. Digital radio broadcasting according to these last systems takes place in the very same frequency bands used for conventional analog radio broadcasting. Consequently, the antenna (1), the radiofrequency amplifier (2), the local oscillator (3), the mixer (4), the intermediate frequency stage (or stages) (5) may be shared by digital and analog receivers. An analog to digital converter (40) is connected to the output of the last intermediate frequency stage (5). Its output is then connected to a digital signal processor (41) and to a decoder (42) for extracting the high quality audio signal and other information sent together with the audio signal, intended for being shown on a display (47). Last, the audio signal is converted from digital to analog (48) and carried to an audio amplifier (7) for driving the speakers (8). The radio listener may choose among the digital channel or the analog channel using the switch (60). Both channels may be coincident, for the whole or just during some intervals, depending upon each station/chain criteria. The selecting device (20) controlled by the radio listener is intended for choosing one among several predetermined frequencies to which the loyalty-generating and pick-up device can be tuned to. The selecting device must change not only the local oscillator frequency and the radio frequency amplifier bandpass but all the required circuits involved: antenna, intermediate frequency stages, detector circuits, etc.

Anyway, the predetermined frequencies to which the device can be tuned to are just a part of the whole set of frequencies allocated for commercial broadcasting by public authorities (i.e. it is impossible for the radio listener of the radiophonic audience loyalty-generating and pick-up device to tune the whole set of allocated frequencies in at least one band at which the receiver operates).

If the loyalty-generating and pick-up device is intended for tuning just one frequency/program, the selector device (20) is obviously superfluous.

The use of the RDS or RBDS techniques open new chances to embody the device. The radiophonic audience loyalty-generating and pick-up device is built from a radio receiver intended for commercial broadcasting (figure 8) comprising a decoder circuit (53) for RDS/RBDS systems, a register (54) for storage of codes that according to RDS/RBDS systems identify each radio station/chain, a sweep generator (51) for scanning frequency through the bands and a comparator inside the tuning controller (50) for comparing the information determining the tuned station with the corresponding information stored in the said register (54). When turning on the radiophonic audience loyalty-generating and pick-up device the sweep generator (51) is enabled; consequently the tuning frequency scans de FM dial in the case of RDS system (both AM and FM dials, in the case of RBDS systems) until the radiophonic audience loyalty-generating and pick-up device is tuned to a frequency which RDS/RBDS code is the same to the value stored in the said register. When this happens, the sweep generator is stopped so that the radiophonic audience loyalty-generating and pick-up device will remain tuned to the predetermined frequency which owns its code stored in the said register (54). If the loyalty-generating and pick up device has been designed for RBDS system, after the frequency sweep has scanned a whole band the tuning controller must change the required elements in order to enable the reception in the next band (the antenna, if required; the radiofrequency amplifier, if necessary; the detector circuit, etc.), because the RBDS extends to AM and LW bands those functions of the RDS system related with stations identification. If the radiophonic audience loyalty-generating and pick-up device has been designed for RDS system, it may receive in AM band or not, and this is why there is a tune control for AM (56) plotted in dashed line (figure 8). In the former case it may happen that all the frequencies of this AM band are allowed for being tuned to or just some of them. The main contribution of the RDS/RBDS technique to the radiophonic audience loyalty-generating and pick-up device is that a unique device can be used by a radio chain all the nation wide.

In order the radiophonic audience loyalty-generating and pick-up device may tune more than one predetermined frequencies (figure 9) a receiver comprising a circuit decoder (53) for RDS/RBDS systems, several registers (55) for storing RDS/RBDS codes for the purpose of identifying each radio station/chain, a selecting device (18) and a sweep generator (51) for the tuning frequency is considered. The radio listener controls the selecting device, which sets the active register (55). The sweep generator (51) is enabled when the radiophonic audience loyalty-generating and pick-up device is turned on. Consequently the tuning frequency scans de FM dial in the case of RDS system (both AM and FM dials, in the case of RBDS systems) until the radiophonic audience loyalty-generating and pick-up device is tuned to a frequency which RDS/RBDS code is the same to the value stored in the said register. When this happens, the sweep generator is stopped so that the radiophonic audience loyalty-generating and pick-up device will remain tuned to the predetermined frequency which owns its code stored in the said register, or to an alternative frequency (AF). If the loyalty-generating and pick up device has been designed for RBDS system, after the frequency sweep has scanned a whole band the tuning controller must change the required elements in order to enable the reception in the next band (the antenna, if required; the radiofrequency amplifier, if necessary; the detector circuit, etc.). If the radiophonic audience loyalty-generating and pick-up device has been designed for RDS system, it may receive in AM band or not, and this is why there is a tune control for AM (56) plotted in dashed line (figure 8). In the former case it may happen that all the frequencies of this AM band are allowed to be tuned to or just some of them.

For the previously referred embodiments, when a given radio station/chain is searched for through one or more bands it may happen that the signal level received were so low that the valid station detector couldn't notice it, thus missing the halt order for the sweep generator. This event can be solved in several ways. For example: the device could enter in an undefined cyclic search loop; or if there are tuning controls they might be enabled after several trials of searching the predetermined radio station/chain. It is of little importance for the present invention the way in which that event is solved. Anyway, the predetermined frequencies to which the device can be tuned are just a part of the whole set of frequencies allocated for commercial broadcasting by public authorities (i.e. it is impossible for the radio listener of the radiophonic audience loyalty-generating and pick-up device to tune the whole set of allocated frequencies in at least one band at which the receiver operates).

In case the radio signals belong to that commercial bands allocated for Digital Audio Broadcasting (DAB), it is possible to build a radiophonic audience loyalty-generating and pick-up device using a receiver comprising (figure 10) a decoding circuit (39) according to the European standard so called Eureka-147, several registers (57) for storing codes which identify some radio stations/chains, a selecting device (36) for setting tuning frequency and also for setting program, because there are more than one channel in each DAB frequency multiplex. The radio listener controls the selector device, which is intended for setting the active register (57). Once the radiophonic audience loyalty-generating and pick-up device is turned on, the required information is taken from the active register. This information is used for setting the local oscillator to the corresponding value in order to tune the frequency multiplex containing the program of the station/chain to which the device should generate loyalty to. This information also determines the radio frequency amplifier bandpass (2), the required frequency for the local oscillator (17), and the required settings for programming the digital signal processor (37) in order the program of the station/chain owning its code in the active register be applied to the audio decoder. The radiophonic audience loyalty-generating and pick-up device may either receive or not in AM, FM or other bands. The former case has been shown in figure 10 by blocks (46) and (49); it may happen that all the frequencies of these bands are allowed to be tuned or just some of them.

The loyalty-generating and pick-up device may be built starting from a receiver intended for that commercial radio broadcasting bands allocated for Digital Audio Broadcasting (DAB) according to the European standard so called Eureka-147, further comprising (figure 11) a digital signal processor (37), an information decoder circuit (39), several registers (57) for storing codes which identify some radio stations/chains accordingly to the said standard, a selecting device (36) and a sweep generator (51) for the tuning frequency and also for the program, because a group of programs are merged in each multiplex and so they are tuned at the same frequency. The radio listener controls the selector device, which is intended for setting the active register (57). The sweep generator (51) is enabled when the radiophonic audience loyalty-generating and pick-up device is turned on. Consequently the tuning frequency scans the band, and inside each multiplex, scans through the programs until the receiver is tuned to a frequency and to a program owning the same code as that obtained by the information decoder (39). When this happens, the sweep generator is stopped so that the radiophonic audience loyalty-generating and pick-up device will remain tuned. The radiophonic audience loyalty-generating and pick-up device may either receive or not in AM, FM or another bands. The former case has been shown in figure 11 by blocks (46) and (49); a switch (60) lets the radio listener to choice among reception in the digital bands or in the analog bands. There is a possibility for the previously referred embodiment in which a given station/chain is searched through one or more bands that the signal level received were so low that the valid station detector couldn't notice it, thus missing the halt order for the sweep generator. This event can be solved in several ways. For example: the device could enter in an undefined cyclic search loop; or if there are tuning controls they might be enabled after several trials of searching the predetermined station/chain. It is of little importance for the present invention the way in which that event is solved.

Anyway, the predetermined frequencies/programs to which the device can be tuned are just a part of the whole set of frequencies/programs allocated for commercial broadcasting by public authorities (i.e. it is impossible for the radio listener of the radiophonic audience loyalty-generating and pick-up device to tune the whole set of allocated frequencies in at least one band at which the receiver operates).

If the loyalty-generating and pick-up device is intended for tuning just one frequency/program, the selector device (36) is obviously superfluous.

## Claims

1. Radiophonic audience loyalty-generating and pick-up device consisting in a radio receiver intended for reception into commercial broadcasting frequency bands comprising a PLL (Phase Locked Loop) frequency synthesizer for the local oscillator. The said receiver further comprises a frequency divider that can only be programmed to certain predetermined counting values among the whole values contained in each given band.

2. Radiophonic audience loyalty-generating and pick-up device according to claim 1, further comprising some paired permanent registers for storing the counting values to be introduced in the programmable divider of the PLL loop and an identification of the frequency band to which each predetermined frequency belongs to, and further comprising a selecting device controlled by the radio listener for activating a pair of registers. Each position of the said selection device corresponding to the tuning of one of the said predetermined frequencies.

3. Radiophonic audience loyalty-generating and pick-up device according to claim 1, further comprising tuning controls, a register matrix and a tuning controller. The said register matrix stores the counting values that are not allowed to the frequency divider of the said PLL loop, each one corresponding to an excluded frequency; also a kind of indication referring to the related band to which each excluded frequency belongs to is stored for each counting value, if not all the excluded frequencies belong to the same band. When a frequency is demanded from the tuning controls, the said tuning controller firstly compares that required frequency - in its related band - with those frequencies corresponding to counting values stored in the said register matrix, so that only non excluded frequencies are allowed for tuning.

4. Radiophonic audience loyalty-generating and pick-up device according to claim 1, further comprising tuning controls and because the programmable divider of the PLL loop further comprises a decoder for avoiding some counting values among the whole values contained in each given band.

5. Radiophonic audience loyalty-generating and pick-up device according to claims 2, 3 or 4, further comprising an analog to digital converter, a signal processor for extracting information coded accordingly to IBOC/IBAC digital radio broadcasting systems, a digital to analog converter, an audio decoder and a switch for selecting between analog program and digital program.

6. Radiophonic audience loyalty-generating and pick-up device consisting in a radio receiver intended for reception into commercial broadcasting frequency bands comprising a set of inductive or capacitive impedances for adjusting the bandpass for the radiofrequency signal, another set of inductive or capacitive impedances for adjusting the local oscillator frequency, a selector controlled by the radio listener and a fine tuning circuit.

7. Radiophonic audience loyalty-generating and pick-up device according to claim 6 in which the fine tuning circuit has got an extended adjusting range in order to allow to be tuned several adjacent predetermined frequencies.

8. Radiophonic audience loyalty-generating and pick-up device according to claim 6 in which the radiofrequency amplifier bandpass is adjusted for receiving a single predetermined frequency and in which the local oscillator is made upon a resonator manufactured for oscillating at the fixed frequency needed in the local oscillator in order the said predetermined frequency to be tuned at the receiver.

9. Radiophonic audience loyalty-generating and pick-up device according to claims 7 or 8, further comprising an analog to digital converter, a signal processor for extracting information coded accordingly to IBOC/IBAC digital radio broadcasting systems, an audio decoder, a digital to analog converter and a switch for selecting between analog program and digital program.

10. Radiophonic audience loyalty-generating and pick-up device consisting in a radio receiver intended for reception into commercial broadcasting frequency bands comprising a PLL (Phase Locked Loop) frequency synthesizer for the local oscillator. The said receiver further comprises a circuit for decoding tuning useful information, some permanent registers for storing codes identifying radio stations/chains, a sweep generator for the tuning frequency and a selector device controlled by the radio listener for determining the active register among the said registers.

11. Radiophonic audience loyalty-generating and pick-up device according to claim 10 in which the circuit for decoding information may perform picking up and decoding information according to the RDS system.

12. Radiophonic audience loyalty-generating and pick-up device according to claim 10 in which the circuit for decoding information may perform picking up and decoding information according to the RBDS system.

13. Radiophonic audience loyalty-generating and pick-up device made upon a digital radio broadcasting receiver according to Eureka-147 digital radio broadcasting standard further comprising several permanent registers for storing the codes which identify some radio stations/chains and a selector device controlled by the radio listener for determining the active register among the said registers, thus fixing the program being received.

14. Radiophonic audience loyalty-generating and pick-up device according to claim 13 further comprising a Program Associated Data (PAD) decoder circuit and a sweep generator for scanning through the tuning frequency and through the programs included in each frequency multiplex.

## Amended claims

### Amended claims under Art. 19.1 PCT

1. Radiophonic audience loyalty-generating and pick-up device consisting in a radio receiver intended for reception into commercial broadcasting frequency bands comprising a PLL (Phase Locked Loop) frequency synthesizer for the local oscillator. The said receiver further comprises a frequency divider that can only be programmed to certain predetermined counting values among the whole values contained in each given band, so that the receiver can only be tuned to the frequencies corresponding to the said predetermined counting values.

2. Radiophonic audience loyalty-generating and pick-up device according to claim 1, further comprising some paired permanent registers for storing the counting values to be introduced in the programmable divider of the PLL loop and an identification of the frequency band to which each predetermined frequency belongs to, and further comprising a selecting device controlled by the radio listener for activating a pair of registers. Each position of the said selection device corresponding to the tuning of one of the said predetermined frequencies.

3. Radiophonic audience loyalty-generating and pick-up device according to claim 1, further comprising tuning controls, a register matrix and a tuning controller. The said register matrix stores the counting values that are not allowed to the frequency divider of the said PLL loop, each one corresponding to an excluded frequency; also a kind of indication referring to the related band to which each excluded frequency belongs to is stored for each counting value, if not all the excluded frequencies belong to the same band. When a frequency is demanded from the tuning controls, the said tuning controller firstly compares that required frequency - in its related band - with those frequencies corresponding to counting values stored in the said register matrix, so that only non excluded frequencies are allowed for tuning.

4. Radiophonic audience loyalty-generating and pick-up device according to claim 1, further comprising tuning controls and because the programmable divider of the PLL loop further comprises a decoder for avoiding some counting values among the whole values contained in each given band.

5. Radiophonic audience loyalty-generating and pick-up device according to claims 2, 3 or 4, further comprising an analog to digital converter, a signal processor for extracting information coded accordingly to IBOC/IBAC digital radio broadcasting systems, a digital to analog converter, an audio decoder and a switch for selecting between analog program and digital program.

6. Radiophonic audience loyalty-generating and pick-up device consisting in a radio receiver intended for reception into commercial broadcasting frequency bands comprising a set of inductive or capacitive impedances for adjusting the bandpass for the radiofrequency signal, another set of inductive or capacitive impedances for adjusting the local oscillator frequency, a selector controlled by the radio listener and a fine tuning circuit.

7. Radiophonic audience loyalty-generating and pick-up device according to claim 6 in which the fine tuning circuit has got an extended adjusting range in order to allow to be tuned several adjacent predetermined frequencies.

8. Radiophonic audience loyalty-generating and pick-up device according to claim 6 in which the radiofrequency amplifier bandpass is adjusted for receiving a single predetermined frequency and in which the local oscillator is made upon a resonator manufactured for oscillating at the fixed frequency needed in the local oscillator in order the said predetermined frequency to be tuned at the receiver.

9. Radiophonic audience loyalty-generating and pick-up device according to claims 7 or 8, further comprising an analog to digital converter, a signal processor for extracting information coded accordingly to IBOC/IBAC digital radio broadcasting systems, an audio decoder, a digital to analog converter and a switch for selecting between analog program and digital program.

10. Radiophonic audience loyalty-generating and pick-up device consisting in a radio receiver intended for reception into commercial broadcasting frequency bands comprising a PLL (Phase Locked Loop) frequency synthesizer for the local oscillator. The said receiver further comprises a circuit for decoding tuning useful information, some permanent registers for storing codes identifying radio stations/chains, a sweep generator for the tuning frequency and a selector device controlled by the radio listener for determining the active register among the said registers.

11. Radiophonic audience loyalty-generating and pick-up device according to claim 10 in which the circuit for decoding information may perform picking up and decoding information according to the RDS system.

12. Radiophonic audience loyalty-generating and pick-up device according to claim 10 in which the circuit for decoding information may perform picking up and decoding information according to the RBDS system.

13. Radiophonic audience loyalty-generating and pick-up device made upon a digital radio broadcasting receiver according to Eureka-147 digital radio broadcasting standard further comprising several permanent registers for storing the codes which identify some radio stations/chains and a selector device controlled by the radio listener for determining the active register among the said registers, thus fixing the program being received.

14. Radiophonic audience loyalty-generating and pick-up device according to claim 13 further comprising a Program Associated Data (PAD) decoder circuit and a sweep generator for scanning through the tuning frequency and through the programs included in each frequency multiplex.

Statement under Art. 19.1 PCT
In the five patents referred by the examiner as Relevant Documents several inventions are described that share with the proposed invention the structure of PLL radio broadcasting receiver comprising pretunes (all of it belongs to the known state of the art). In all the mentioned inventions the said pretunes are intended for easing the tuning effort to the radio listener when desired to be tuned some stations complying with certain requisites. But the receiver can always be tuned to any station in the dial. This is a main difference compared to the proposed invention, as it is repeatedly explained in the description. Claim 1 has been changed, in order to include explicitly this difference into the characterizing part.

**(X) GB 2 289 585 A:** It describes an invention intended for short wave receivers. Short waves are transmitted all over the world involving the ionosphere and may be much disturbed in their propagation, which greatly depends on the hour of the day and on the world zone in which is located the receiver. Some broadcasters send the same radio signal at different frequencies, in order their emissions could always be received almost anywhere in at least one frequency. The invention adds a real time clock and means for specifying the time difference between local time and GMT time reference. Also there are some pretunes for choosing the frequency for best reception of the required station, depending upon the world zone and the hour of the day. Consequently tuning is simplified for the radio listener, who otherwise should use tables for finding the recommended frequency for listening to a particular station as a function of the hour of the day and of the geographic position.

**(X) EP 0 760 557 A1:** The receiver comprises an automatic system known in the state of the art intended for: scanning through the band, detecting the best signal stations and storing them into pretuning controls. The invention comprise an intermediate buffer for easing the radio listener making interchanges between registers, because the first arrangement of pretunes corresponds to increasing frequencies, instead of being ordered by the radio listener preferred stations.

**(X) EP 0 513 477 A2:** The inventor states that the stations are specialized in different types of programs (for example jazz, rock & roll, voice, etc.). For best results each station requires a particular setting for the audio amplifier equalizer. The invention propose a way for associating the equalizer settings to each frequency pretuned by the radio listener, in order the equalizer be correspondingly adjusted each time a pretuned frequency is selected.

**(A) EP 0 736 985 A2:** The receiver comprises a digital data decoder for extracting data sent with the FM signal, using a system known in the state of the art. As most radio stations do not include additional data to their signal, the inventor proposes a device for searching among those stations that send additional information over the FM band, then storing them into some pretune controls. This way the radio listener may choose easily an station that sends additional data together with the FM signal.

**(A) US 4 344 187 A:** The invention consists in a system intended for keeping best tuned the receiver, correcting slight drifts that can arise. It also includes a conventional pretunes system.
